# EUROPÄISCHE PATENTSCHRIFT

(11) **EP 3 360 219 B1**
(45) Veröffentlichungstag und Bekanntmachung des Hinweises auf die Patenterteilung: **30.09.2020**
(21) Anmeldenummer: 16751534.5
(22) Anmeldetag: 02.08.2016
(51) Int. Cl.: H02H 9/00, H02H 9/02, H02H 3/08, H02H 3/42, H02H 1/04, H03K 17/00

(54) **ELEKTRONISCHER SCHUTZSCHALTER**
ELECTRONIC CIRCUIT BREAKER
DISJONCTEUR ÉLECTRONIQUE

(30) Priorität: 08.10.2015 DE 102015219545
(43) Veröffentlichungstag der Anmeldung: 15.08.2018
(73) Patentinhaber: Ellenberger & Poensgen GmbH, 90518 Altdorf (DE)
(72) Erfinder: ASANZA MALDONADO, Diego Fernando, 90403 Nürnberg (DE)
(74) Vertreter: FDST Patentanwälte
(86) Internationale Anmeldenummer: PCT/EP2016/068464
(87) Internationale Veröffentlichungsnummer: WO 2017/059983

(56) Entgegenhaltungen:
- EP-A2- 2 403 088
- WO-A1-2015/024754
- DE-A1- 19 938 716
- DE-A1-102005 038 124
- DE-A1-102011 120 466
- DE-U1- 20 010 283

## Beschreibung

Die Erfindung betrifft einen elektronischer Schutzschalter mit einer Steuereinheit und mit einem steuerbaren Halbleiterschalter, der in einen Strompfad zwischen einem Spannungseingang und einem Lastausgang geschaltet ist, gemäß dem Oberbegriff des Anspruchs 1. Sie betrifft weiter ein Verfahren zur Steuerung eines solchen elektronischen Schutzschalters gemäß dem Oberbegriff des Anspruchs 6. Ein derartiger Schutzschalter und ein solches Verfahren sind beispielsweise aus der DE 10 2005 038 124 A1 bekannt.

Ein aus der DE 203 02 275 U1 bekannter elektronischer Schutzschalter weist einen Halbleiterschalter in Form eines MOSFET (Metall-Oxid-Halbleiter-Feldeffekttransistor) auf, der zwischen einen Betriebsspannungsanschluss und einen Lastanschluss in einen Strompfad geschaltet ist. Um in einem Gleichspannungsnetz eine zuverlässige Strombegrenzung zu erreichen, wird ein von einem Stromsensor im Strompfad erfasster Messwert einem Komparatoreingang einer Regeleinrichtung zugeführt. Bei Vorliegen eines Einschaltsignals und bei einem einen Referenzwert unterschreitenden Messwert steuert die Regeleinrichtung den Halbleiterschalter auf, während bei einem den Referenzwert überschreitenden Messwert die Regeleinrichtung den Leistungstransistor zusteuert und den über diesen fließende Strom auf den Referenzwert begrenzt.

Aus der EP 1 186 086 B1 ist ein Stromverteilungssystem im Niedervoltbereich, insbesondere im 24V DC-Bereich, mit einer Anzahl von Stromkreisen mit jeweils einem elektronischen Schutzschalter als Kurzschluss- und/oder Überlastschutz bekannt. Die Stromkreise sind mittels eines getakteten Netzteils gemeinsam gespeist. Im Überlastfall erfolgt bei Überschreiten einer einstellbaren Stromschwelle, z. B. beim 1,1-Fachen des Nennstroms (I_{N}) eine Sperrung des elektronischen Schutzschalters nach Ablauf einer Verzögerungszeit, während im Kurzschlussfall zunächst eine Strombegrenzung und nach Überschreiten einer weiteren Stromschwelle (z. B. 2 x I_{N}) eine Sperrung des Schutzschalters nach Ablauf einer bestimmten Abschaltzeit erfolgt.

Aus der EP 1 150 410 A2 ist ein mittels eines Mikroprozessors über einen Auslösekreis angesteuerter elektronischer Schutzschalter bekannt, der die Energieversorgung zu einer Last mit einer Zeitverzögerung unterbricht. Zuvor oder zeitgleich erfolgt eine partielle Unterbrechung des Schutzschalters.

Eine partielle Unterbrechung eines elektronischen Schutzschalters mit mehreren Schaltblöcken, die jeweils einen elektronischen Schalter in Form eines MOSFET und einen diesen über einen gemeinsamen Mikroprozessor steuernden Komparator aufweisen, ist auch aus der EP 1 294 069 B1 bekannt. Im Falle eines Überstroms wird die Energieversorgung zur Last nach einer Zeitverzögerung unterbrochen, die auf eine partielle Untersagung des wenigstens einen Schalters folgt.

Zum Schalten insbesondere kapazitiver Lasten und/oder zu deren Schutz gegen Überstrom und Kurzschluss wird der Halbleiterschalter des elektronischen Schutzschalters als Konstantstromquelle zum Laden der Kapazität genutzt. Der Halbleiterschalter und insbesondere ein hierbei eingesetzter MOSFET muß in der Lage sein, während des Schaltens beziehungsweise im Zuge des Ladens der Kapazität die Verlustleistung in Folge des Einschaltstroms tragen zu können. Aufgrund dieser Situation werden elektronische Schutzschalter, insbesondere solche mit aktiver Strombegrenzung, üblicherweise mit einem überdimensionierten Halbleiterschalter (MOSFET) ausgelegt, um dieser Verlustleistung ausreichend Rechnung zu tragen. Eine derartige Dimensionierung des eingesetzten Halbleiterschalters führt jedoch zu einem erhöhten Kostenaufwand und einem entsprechend großen Raumbedarf innerhalb der Schaltung des elektronischen Schutzschalters.

Der Erfindung liegt die Aufgabe zugrunde, unter Vermeidung der genannten Nachteile einen möglichst effektiv arbeitenden elektronischen Schutzschalter anzugeben, wobei ein überdimensionierter Halbleiterschalter sowie dessen aufwändige Ansteuerung vermieden werden sollen. Des Weiteren soll ein geeignetes Verfahren zur Steuerung (Ansteuerung) eines solchen elektronischen Schutzschalters, insbesondere auch während eines Einschaltvorgangs einer Last, angegeben werden.

Bezüglich des elektronischen Schutzschalters wird die genannte Aufgabe mit en Merkmalen des Anspruchs 1 und hinsichtlich des Verfahrens mit den Merkmalen des Anspruchs 7 erfindungsgemäß gelöst. Vorteilhafte Ausgestaltungen und Weiterbildungen sind Gegenstand der rückbezogenen Unteransprüche.

Erfindungsgemäß ist der steuerbare Halbleiterschalter unter Bildung einer spannungsgesteuerten Stromquelle verschaltet, d. h. in eine entsprechende spannungsgesteuerte Stromquellenschaltung integriert. Deren Ausgangsstrom ist bei angeschlossener Last mittels einer Steuereinheit derart eingestellt, dass die Leistung des Halbleiterschalters stets kleiner oder gleich einem maximalen Leistungswerts ist. Die Steuereinheit gibt einen Sollwert des Ausgangsstroms an die spannungsgesteuerte Stromquellenschaltung und erhält von dieser einen Differenzwert, der aus einer Abweichung des Ausgangsstroms vom Sollwert gebildet ist. Der Differenzwert dient zur Ansteuerung des Halbleiterschalters und ist diesem steuerseitig als Steuersignal (Steuerspannung) zugeführt.

Die Steuereinheit des elektronischen Schutzschalters stellt im Überlast- oder Kurzschlussfall und somit auch bei einem Einschalten auf eine kapazitive Last den Sollwert des Ausgangsstroms derart ein, dass dieser unter Berücksichtigung des maximalen Leistungswertes des Halbleiterschalters ausgehend von einem Minimalwert nur bei über die Zeit ansteigender Ausgangsspannung ebenfalls ansteigt. Die Vorgabe des Sollwertes durch die Steuereinheit des elektronischen Schutzschalters erfolgt dabei geeigneterweise in diskreten Schritten, sodass der Ausgangsstrom (Laststrom) stufenweise ansteigt. Während der Phasen oder Stufen konstanten Ausgangsstroms stellt die Steuereinheit anhand der erfassten Ausgangsspannung fest, ob diese ansteigt oder nicht. Falls die Ausgangsspannung ansteigt, wird der Sollwert auf einen nächst höheren Wert gesetzt, sodass auch der Ausgangsstrom ebenfalls auf einen höheren Stufenwert ansteigt. Dieser Vorgang wird wiederholt, bis unter der Voraussetztung der stetig ansteigenden Ausgangsspannung ein Maximalwert erreicht ist. Andernfalls, wenn die Ausgangsspannung nicht ansteigt, wird der Halbleiterschalter gesperrt, sodass der elektronische Schutzschalter auslöst und die Last vom Strompfad trennt.

Der Steuereinheit sind hierzu geeigneterweise eine den Ausgangsstrom repräsentierende Spannung der spannungsgesteuerten Stromquelleschaltung als Istwert und deren Ausgangsspannung zugeführt. Weicht der in oder von der spannungsgesteuerten Stromquelleschaltung gebildete Differenzwert im Überlast- oder Kurzschlussfall oder bei einem Einschalten auf eine kapazitive Last von einem Schwellwert ab, so wird dieser Zustand von der Steuereinheit anhand des Differenzwertes erkannt und es erfolgt vorzugsweise zunächst eine Strombegrenzung. Zudem stellt die Steuereinheit den Sollwert des Ausgangsstroms derart ein, dass der maximale Leistungswert des Halbleiterschalters nicht überschritten wird, dieser also stets unter Berücksichtigung seines maximalen Leistungsverlustes innerhalb dessen Sicherheitsbereich (safe operation area) arbeitet.

In besonders geeigneter Ausgestaltung weist die spannungsgesteuerte Stromquellenschaltung des elektronischen Schutzschalters einen als Komparator arbeitenden Operationsverstärker auf, dem eingangsseitig der den Ausgangsstrom repräsentierende Istwert und von der Steuereinheit der Sollwert des Ausgangsstroms zugeführt ist. Ausgangsseitig ist der Operationsverstärker mit einem Eingang der Steuereinheit sowie mit dem Halbleiterschalter steuerseitig, vorzugsweise über eine Verstärkerschaltung, verbunden. Der dem Operationsverstärker eingangsseitig zugeführte Istwert sowie der diesem ebenfalls eingangsseitig zugeführte Sollwert sind Spannungswerte, deren Differenz oder Differenzwert am Ausgang des Operationsverstärkers zu einem entsprechenden Spannungsdifferenzwert führt, welcher gleich der oder proportional zur Abweichung des Istwerts vom aktuell vorgegebenen Sollwert ist.

Wird demnach der Sollwert in Abhängigkeit von der aktuellen Ausgangsspannung der spannungsgesteuerten Stromquellenschaltung des elektronischen Schutzschalters vorzugsweise stufenweise auf höhere Werte gesetzt, so liefert der Operationsverstärker ausgangsseitig aufgrund der Differenzbildung mit dem Istwert eine entsprechend ansteigende Steuerspannung für den Halbleiterschalter, sodass dieser entsprechend zunehmend geöffnet (durchgeschaltet) wird und sich der Ausgangsstrom entsprechend erhöht, was wiederum zur Erhöhung des Istwertes führt.

Bei dem Verfahren zur Steuerung des elektronischen Schutzschalter mit in eine spannungsgesteuerte Stromquellenschaltung integriertem Halbleiterschalter werden der Ausgangsstrom sowie vorzugsweise auch die Ausgangsspannung der spannungsgesteuerten Stromquellenschaltung erfasst und die Leistung des Halbleiterschalters kleiner oder gleich einem maximalen Leistungswert eingestellt.

Insbesondere im Kurzschlussfall, d. h. auch während eines Einschaltvorgangs einer kapazitiven Last wird der Ausgangsstrom vorzugsweise zunächst auf einen Stromwert begrenzt. Hierzu wird der Ausgangsstrom der Stromquellenschaltung geeigneterweise als Istwert gespiegelt, der mit einem Sollwert des Ausgangsstroms verglichen wird. Aus dem Ergebnis des Soll-Ist-Vergleichs wird eine Spannungsdifferenz (Differenzwert) gebildet, die (der) direkt zur Ansteuerung des Halbleiterschalters verwendet wird. Die Spannungsdifferenz bzw. der entsprechende Differenzwert löst bei einer Schwellwertabweichung zunächst die Strombegrenzung aus. Anschließend wird in Abhängigkeit von der Ausgangsspannung der Sollwert eingestellt, d.h. insbesondere herabgesetzt oder verringert. Die Einstellung erfolgt dabei derart, dass einerseits die Leistung des Halbleiterschalters kleiner oder gleich dem maximalen Leistungswert ist, und dass andererseits der Ausgangsstrom ausgehend von einem ersten Stromwert (Minimalwert) nur dann erhöht wird, wenn im zeitlichen Verlauf die Ausgangsspannung ansteigt.

Mit anderen Worten wird bei einer Abweichung des als Istwert kontinuierlich erfassten Ausgangsstroms von einem Sollwert ein diese Abweichung repräsentierender Spannungsdifferenzwert einerseits direkt zur Ansteuerung des Halbleiterschalters zum Zwecke einer aktiven Begrenzung des Ausgangsstroms sowie andererseits - unter Berücksichtigung der aktuellen Ausgangsspannung der spanungsgesteuerten Stomquelle - zur Bestimmung der Leistung des Halbleiterschalters auf einen Maximalwert und gegebenfalls zur Leistungsbegrenzung herangezogen, indem der Sollwert des Ausgangsstroms entsprechend eingestellt, d.h. verändert und gegebenenfalls reduziert wird.

Der zur Leistungseinstellung des Halbleiterschalters, insbesondere während eines Einschaltvorgangs des elektronischen Schutzschalters, herangezogene Strommesswert des Ausgangsstroms der Stromquellenschaltung entspricht aufgrund der Reihenschaltung des Halbleiterschalters mit der angeschlossenen Last dem über diese fließenden Laststrom, der mittels einer Spiegelschaltung im Strompfad des Halbleiterschalters und der Last als Spannungsistwert erfasst wird.

Die Leistungseinstellung des Halbleiterschalters erfolgt dann gemäß der Beziehung P = U · I anhand des erfassten Ausgangsstroms und der gemessenen Ausgangs- oder Lastspannung, durch deren Differenz zur gegebenen Eingangsspannung der spannungsgesteuerten Stromquellenschaltung die Spannung über dem Halbleiterschalter, d. h. über dessen Drain-Sourc-Strecke bestimmt ist. Dabei wird der Halbleiterschalter derart angesteuert, dass dessen Leistung (Velustleistung) stets, d. h. in allen Betriebszuständen kleiner oder gleich einem bestimmten, maximalen Leistungswert ist.

Die mit der Erfindung erzielten Vorteile bestehen insbesondere darin, dass der in einer spanungsgesteuerten Stomquelle (Stromquellenschaltung) mit kontinuierlicher Erfassung des Ausgangsstroms verschaltete Halbleiterschalter eines elektronischen Schutzschalters in allen Betriebszuständen und somit auch im Überlast- oder Kurzschlussfall sowie während des Ladevorgangs einer kapazitiven Last leistungsmäßig stets in einem Sicherheitsbereich mit einer Leistung (Verlustleistung) kleiner oder gleich einem maximalen Leistungswert, beispielsweise 50W, arbeitet.

Im Falle eines zeitlich begrenzten Kurzschlusses, insbesondere während des Einschaltvorgangs auf eine kapazitive Last, wird aufgrund des sich einstellenden Spannungsdifferenzwertes der Stromquellenschaltung einerseits der Ausgangs- oder Laststrom mittels des Halbleiterschalters begrenzt und anderserseits dieser Zustand erkannt, indem der sich einstellende Spannungsdifferenzwert erfasst wird. Somit kann der Sollwert für den Ausgangsstrom derart gesetzt werden, dass der maximale Leistungsverlust oder -wert des Halbleiterschalters innerhlalb dessen Sicherheitsbereich liegt.

Aufgrund der zeitgleichen Überwachung der Ausgangsspannung der spanungsgesteuerten Stomquellenschaltung (Stromquelle) wird zudem erkannt, ob diese innerhalb einer ebstimmten Zietspanne ansteigt oder nicht. Gegenenfalls kann der Sollwert des Ausgangsstroms unter Berücksichtigung des leistungsmäßigen Sicherheitsereichs des Halbleiterschalters erhöht werden. Andernfalls wird auf einen dauerhafte Überlast- oder Kurzschlussfall geschlossen und es erfolgt die Abschaltung des elektronischen Schutzschalters, indem der Ausgangsstrom mittels des Halbleiterschalters auf Null gesetzt wird.

Mit dieser Sollwert-Einstellung wird die Leistung des Halbleiterschalters in allen Betriebszuständen kontrolliert, und der Halbleiterschalter kann hinsichtlich der zu beherrschenden Verlustleistung entsprechend kleiner dimensioniert sein. Vorteilhafterweise arbeitet die spannungsgesteuerte Stromquellenschaltung hierbei derart, dass bei Verwendung beispielsweise eines PMOS-Feldeffekttransistiors im Normalbetrieb der aus dem Ist-Soll-Vergleich gebildete und den Halbleiterschalter steuernde Spannungsdifferenzwert kleiner als Null (< 0V) ist. In diesem Zustand kann die Steuereinheit ruhen, ist also entpsrechend leistungsarm. Erst wenn der Spannungsdifferenzwert den Schwellwert überschreitet, also beispielsweise größer als Null (> 0V) wird, reagiert die Steuereinheit, indem diese den Sollwert absenkt und die Ausgangsspannung erfasst sowie anhand deren zeitlichen Verlauf den Sollwert der Ausgangsspannung vorzugsweise in diskreten Schritten anhebt, wenn die Ausgangsspannung innerhalb eines Zeitfensters ansteigt.

Nachfolgend wird ein Ausführungsbeispiel der Erfindung anhand einer Zeichnung näher erläutert. Darin zeigen:
- Fig. 1: in einem Blockschaltbild einen elektronischen Schutzschalter mit einem in den Plus-Strompfad einer spannungsgesteuerten Stromquellenschaltung geschalteten steuerbaren Halbleiterschalter sowie mit einer zu dessen Leistungssteuerung vorgesehenen und eingerichteten Steuereinheit oder -einrichtung in Form beispielsweise eines Mikroprozessors,
- Fig. 2: in einem Flussdiagramm den Verfahrensablauf des Steuerverfahrens des elektronischen Schutzschalters,
- Fig. 3: in einem Strom-Zeit-Diagramm den Verlauf des Ausgangsstroms (Laststrom) der spannungsgesteuerten Stromquellenschaltung des elektronischen Schutzschalters während eines Ladevorgangs einer kapazitiven Last, und
- Fig. 4: in einem mit Fig. 3 korrespondierenden Spannungs-Zeit-Diagramm den Verlauf der Ausgangsspannung der spannungsgesteuerten Stromquellenschaltung im Falle eines gesteuert stufenartigen Anstiegs des Ausgangsstroms.

Einander entsprechende Teile und Parameter sind in allen Figuren mit den gleichen Bezugszeichen versehen.

Der schematisch dargestellte elektronische Schutzschalter 1 umfasst eine spannungsgesteuerte Stromquellenschaltung 2 mit einem Leistungstransistor oder Halbleiterschalter 3 in einem Plus-Strompfad 4 und eine Steuereinheit oder - einrichtung 5, beispielsweise in Form eines Mikrocontrollers. Der Strompfad 3 erstreckt sich zwischen einem Betriebsspannungsanschluss oder Spannungseingangs 6 und einem (positiven) Lastanschluss oder -ausgang 7. An diesen wird der Pluspol einer zu schaltenden Last L angeschlossen, während deren Minuspol gegen Masse oder Ground geführt ist. Die Betriebs- oder Eingangsspannung Vᵢₙ in Form beispielsweise einer Gleichspannung mit 24 V (DC) wird an den Spannungseingang 6 des elektronischen Schutzschalters 1 angelegt. Der steuerbare Halbleiterschalter 3 ist im Ausführungsbeispiel durch einen sogenannten PMOS (p-Kanal-MOSFET oder PMOSFET) realisiert, d. h. einem Metall-Oxid-Halbleiter-Feldeffekttransistor, bei dem positiv geladene Ladungsträger (Defektelektronen) zur Leitung des elektrischen Stroms durch den Kanal genutzt werden.

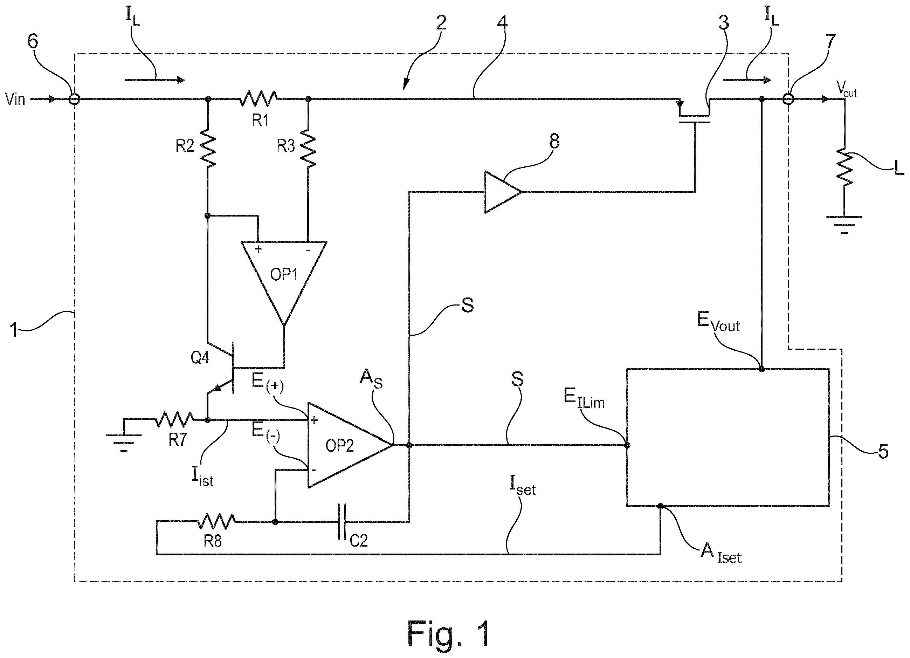

Bei angeschlossener Gleichspannungsquelle und angeschlossener Last L fließt beim Betrieb des Schutzschalters 1 ausgehend vom Spannungseingang 6 über den Strompfad 3 und somit über die Drain-Source-Strecke des Halbleiterschalters 3 sowie über die Last L ein Laststrom gegen Bezugspotential oder Ground (Masse) ab. Dieser über den Halbleiterschalter 3 und die Last L fließende Laststrom entspricht dem Ausgangsstrom I_{L} der spannungsgesteuerten Stromquellenschaltung 2. Der Ausgangsstrom I_{L} wird mittels der spannungsgesteuerten Stromquellenschaltung 2 erfasst. Hierzu umfasst diese die Widerstände R1 bis R3 und den Operationsverstärker OP1 sowie den Transistor Q4 und den gegen Ground (Masse) bzw. Bezugspotential geführten Widerstand R7 in deren in Figur 1 gezeigten Verschaltung.

Mit den Widerständen R1, R2, R3 und dem Operationsverstärker OP1 sowie mit dem Transistor Q4 und mit dem gegen Masse geschalteten Widerstand R7 der spannungsgesteuerten Stromquellenschaltung 2 erfolgt quasi eine Stromspiegelung, indem der über den Widerstand R1 fließende Ausgangsstrom I_{L} am Widerstand R7 auf einen vergleichsweise geringen Stromwert quasi gespiegelt wird. Beträgt der Ausgangsstrom beispielsweise 1 A, so beträgt der über den Widerstand R7 fließende Strom beispielsweise 1 mA. Der entsprechende Spannungswert am Widerstand R7 wird dem Plus-Eingang des Operationsverstärkers OP2 als Istwert Iᵢₛₜ des Ausgangsstroms I_{L} zugeführt.

Die spannungsgesteuerten Stromquellenschaltung 2 umfasst im Wesentlichen einen als Komparator zur Differenzbildung arbeitenden Operationsverstärker OP2, an dessen (positiven) Eingang E₍₊₎ der Widerstand R7 und somit der Istwert Iᵢₛₜ des Ausgangsstroms I_{L} geführt ist. Der invertierende Eingang E₍₋₎ des Operationsverstärkers OP2 ist über einen Widerstand R8 an einen Ausgang Aₗₛₑₜ der Steuereinheit 5 geführt. Über den Ausgang Aₗₛₑₜ liefert die Steuereinheit 5 einen Sollwert Iₛₑₜ des Ausgangsstroms I_{L} an den Operationsverstärker OP2. Zwischen den Ausgang A_{S} und den invertierden Eingang E₍₋₎ des Operationsverstärkers OP2 ist ein Kondensator C2 geschaltet.

Der Ausgang A_{S} des Operationsverstärkers OP2 der spannungsgesteuerten Stromquellenschaltung 2 ist an einen Eingang E_{ILim} der Steuereinheit 5 geführt. Ein weiterer Eingang E_{Vout} der Steuereinheit 5 ist zwischen dem Halbleiterschalter 3 und dem Lastanschluss 7 an den Strompfad 4 geführt. Zudem ist der Ausgang A_{S} des Operationsverstärkers OP2 der Stromquellenschaltung 2 mit dem Halbleiterschalter 3 steuerseitig, d. h. mit dessen Steuereingang (Gate) verbunden. Im Ausführungsbeispiel erfolgt dies über einen Verstärker 8 der spannungsgesteuerten Stromquellenschaltung 2.

Im normalen Betriebszustand des elektronischen Schutzschalters 1 und dessen spannungsgesteuerter Stromquellenschaltung 2 ist der Ausgang Aₗₛₑₜ der Steuereinheit 5 und damit der Sollwert Iₛₑₜ derart gesetzt, dass der Ausgangsstrom I_{L} vorzugsweise größer ist als der maximale Laststrom ist. Unter diesen normalen Bedingungen wird die Last- bzw. Ausgangsspannung Vₒᵤₜ des elektronischen Schutzschalters 1 gleich dessen Eingangsspannung Vᵢₙ sein.

Im Überlast- oder Kurzschlussfall oder beim Einschalten auf eine kapazitive Last L wird zunächst der Ausgangsstrom I_{L} auf einen Nominalwert I_{Nom} aktiv begrenzt, indem der Halbleiterschalter 3 entsprechend angesteuert wird. Dieser Zustand wird von der Steuereinheit 5 erkannt, da diese mit dem Ausgang A_{S} des Operationsverstärkers OP2 verbunden ist, der die Differenz zwischen dem aktuellen Istwert Iᵢₛₜ und dem vorgegebenen Sollwert Iₛₑₜ bildet und ausgangsseitig einen entsprechend veränderten Differenzwert S als Steuersignal (Steuerspannung) für den Halbleiterschalter 3 liefert. Dieser veränderte Differenzwert S des Operationsverstärkers OP2 führt zu einer entsprechenden Ansteuerung des Halbleiterschalters 3, sodass dieser entsprechend zugesteuert und der Ausgangsstrom I_{L} auf einen Strombegrenzungswert Iₘₐₓ begrenzt wird. Der Überlast- oder Kurzschlussfall wird zudem anhand der sich ändernden Ausgangsspannung (Lastspannung) Vₒᵤₜ von der Steuereinheit 5 erfasst.

Sobald die Überlast oder der Kurzschluss erkannt wird, wird der Ausgangsstrom I_{L} der spannungsgesteuerten Stromquellenschaltung 2 derart durch entsprechende Änderung des Sollwertes Iₛₑₜ gesetzt, dass die maximalen Leistungsverluste Pₘₐₓ des Halbleiterschalters 3 innerhalb dessen Sicherheitsbereiches (Safe Operation Aerea) liegt. Gleichzeitig wird die Ausgangsspannung Vₒᵤₜ überwacht.

Falls innerhalb einer vorgebbaren Zeitspanne die Ausgangsspannung Vₒᵤₜ nicht ansteigt, wird der Ausgangsstrom I_{L} auf null (0A) gesetzt, d.h. der elektronische Schutzschalter 1 schaltet den Lastausgang oder -anschluss 7 aus.

Falls hingegen die Ausgangsspannung Vₒᵤₜ ansteigt, so wird der Sollwert Iₛₑₜ innerhalb des Sicherheitsbereichs des Halbleiterschalters 3 vorzugsweise stufenweise erhöht, sodass auch der Ausgangsstrom I_{L} entsprechend stufenweise ansteigt. Dabei bleibt die Leistung, d.h. die Verlustleistung des Halbleiterschalters 3 stets kleiner oder gleich dem maximalen Leistungswert Pₘₐₓ. Dies erfolgt mittels der Steuereinheit 5 durch Bildung des Produkts (Vₒᵤₜ · Iₛₑₜ) aus dem Sollwert Iₛₑₜ und der Ausgangsspannung Vₒᵤₜ. Die Erhöhung des Sollwertes Iₛₑₜ innerhalb des zulässigen Leistungsbereichs des Halbleiterschalters 3 erfolgt vorzugsweise schrittweise, bis die Ausgangsspannung Vₒᵤₜ erneut gleich der Eingangsspannung Vᵢₙ des elektronischen Schutzschalters 3 bzw. dessen Stromquellenschaltung 2 ist.

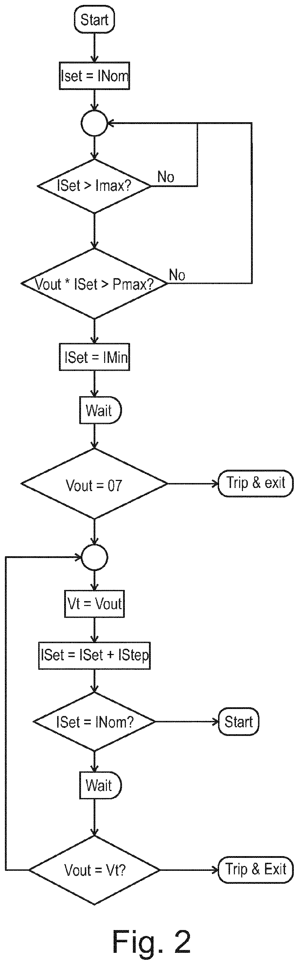

Dieses Steuerverfahren, das sich insbesondere auch beim Einschalten des elektronischen Schutzschalters 1 auf eine kapazitive Last L eignet, ist in dem in Fig. 2 gezeigten Flussdiagramm veranschaulicht. Nach dem Start, d. h. mit dem Einschalten des elektronischen Schutzschalters 1 ist der Sollwert Iₛₑₜ von der Steuereinheit 5 auf den jeweiligen Nominalstrom I_{Nom} gesetzt. Anschließend erfolgt die Abfrage, ob der gesetzte Sollwert Iₛₑₜ größer als der Strombegrenzungs- oder Maximalwert Iₘₐₓ ist. Ist dies der Fall, so wird im nächsten Schritt das Produkt aus dem aktuellem Sollwert Iₛₑₜ und der aktueller Ausgangsspannung Vₒᵤₜ gebildet und abgefragt, ob dieses Produkt größer als der maximale Leistungswert Pₘₐₓ ist. Ist dies der Fall, so wird der Sollwert Iₛₑₜ auf einen Minimalwert I_{Min} gesetzt. Dieser entspricht vorzugsweise einem Bruchteil von beispielsweise 20% des Nominalwertes I_{Nom} des Ausgangsstroms I_{L}.

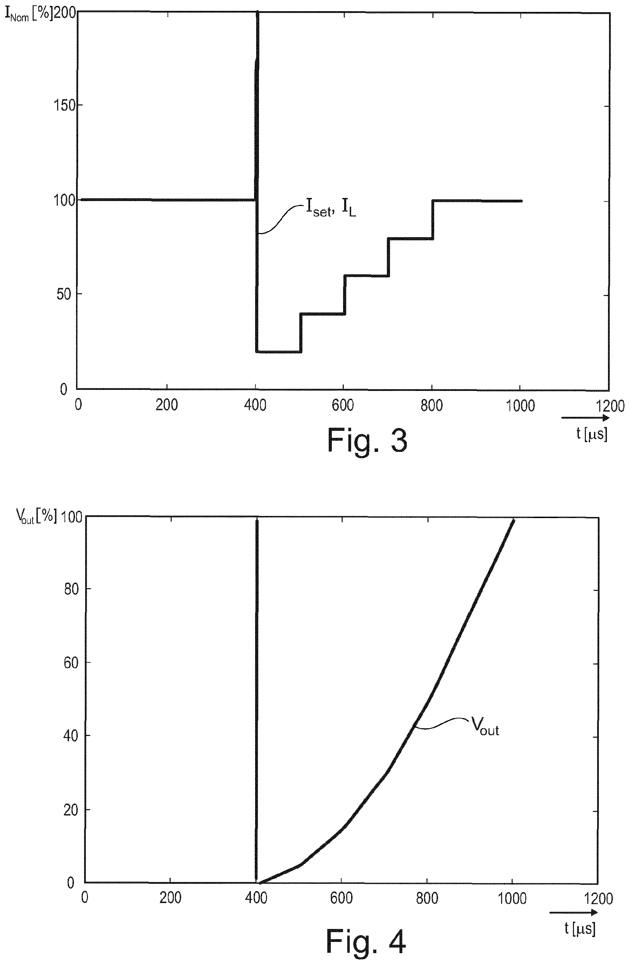

Fig. 4 zeigt diesen Zustand anhand des Strom-Zeit-Diagramms I_{Nom}(t), wobei auf der x-Achse die Zeit t in µs und auf der y-Achse der normierte Last- bzw. Ausgangsstrom I_{L} als Nominalwert I_{Nom} (in %) aufgetragen ist. Im Ausgangszustand ist der Sollwert Iₛₑₜ auf den Nominalwert I_{Nom} des Ausgangsstroms I_{L} gesetzt. Dieser Zustand beibt erhalten, solange der Sollwert Iₛₑₜ den Maximalwert Iₘₐₓ und die Leistung (Vₒᵤₜ · Iₛₑₜ) des Halbleiterschalters 3 den maximalen Leistungswert Pₘₐₓ unterschreitet.

Zum Zeitpunkt t = 400 erfolgt die Einschaltung des Schutzschalters 1 auf die kapazitive Last L. Quasi zeitgleich setzt die Steureinheit 5 den Sollwert Iₛₑₜ des Ausgangsstroms I_{L} auf 20% des Nominalwertes I_{Nom}. Mit der Herabsetzung des Sollwertes Iₛₑₜ wird über den Operationsverstärker OP2 der Halbleiterschalter 3 anhand des Differenzwertes S entsprechend zugesteuert. Nach einer vorgebbaren Zeitspanne mit beispielsweise Δt = 100 wird die Reaktion auf diese Einstellung bzw. Steuerung oder Regelung erfasst, indem die aktuelle Ausgangsspannung Vₒᵤₜ(t = 500) abgefragt wird. Ist die Ausgangsspannung null (Vₒᵤₜ = 0), so löst der elektronische Schutzschalter 3 aus. Ist hingegen die Ausgangsspannung ungleich null (Vₒᵤₜ ≠ 0), d. h. hat die Ausgangsspannung Vₒᵤₜ einen gewissen Spannungswert Vₜ > 0 erreicht, so wird der Sollwert Iₛₑₜ um einen Stufenwert Iₛₜₑₚ erhöht, der beispielsweise 30% des Normalstroms I_{Nom} entspricht.

Anschließend erfolgt die Abfrage, ob der Sollwert Iₛₑₜ bereits den Nominalwert I_{Nom} erreicht hat. Ist dies der Fall, so beginnt der Steueralgorithmus erneut mit der Abfrage, ob der Sollwert Iₛₑₜ dem Nominalwert I_{Nom} entspricht. Ist dies nicht der Fall, so wird unter Abfrage der Ausgangsspannung Vₒᵤₜ und insbesondere dessen Anstiegs infolge der stufenweisen Heraufsetzung des Sollwertes Iₛₑₜ der Programmablauf beginnend mit einer weiteren Sollwerterhöhung Iₛₜₑₚ durchlaufen. Überschreitet die Ausgangsspannung Vₒᵤₜ den Spannungswert Vₜ nicht, so erfolgt erneut die Auslösung des elektronischen Schutzschalters 3.

Der Zusammenhang zwischen dem sukzessiven, vorzugsweisen stufenartigen Anstieg des Sollwertes Iₛₑₜ und damit des Ausgangsstroms I_{L} einerseits mit dem zeitlichen Verlauf der normierten Last- bzw. Ausgangsspannung Vₒᵤₜ(%) andererseits ist aus den in den Fig. 3 und 4 gezeigten Diagrammen ersichtlich. Steigt demnach mit sukzessiver Erhöhung des Sollwertes Iₛₑₜ der Ausgangsstrom I_{L} und mit diesem auch die Ausgangsspannung Vₒᵤₜ kontinuierlich an, so wird der Sollwert Iₛₑₜ erhöht, bis der Ausgangsstrom I_{L} den Nominalwert I_{Nom} erreicht. Der in Fig. 4 veranschaulichte Spannungsverlauf über die Zeit t in µs repräsentiert den typischen Einschaltfall auf eine kapazitive Last L.

Mittels des Verfahrens und anhand dem in Fig. 2 veranschaulichten Flussdiagramm entsoprechenden Algorithmus kann der Halbleiterschalter 3 im Rahmen einer konstanten Strombegrenzung derart angesteuert werden, dass im Überlast- oder Kurzschlussfall der Ausgangs- oder Laststrom I_{L} zumindest kurzzeitig auf einen vorgegeben maximalen Strombegrenzungswert Iₘₐₓ begrenzt wird, und dass dabei dessen Verlustleistung kleiner oder gleich dem maximalen Leistungswert Pₘₐₓ ist. Der Strombegrenzungswert Iₘₐₓ beträgt beispielsweise dem 1,5- bis 2-fachen des Nennstroms des Schutzschalters 1.

Aufgrund der Vorgabe des Sollwertes Iₛₑₜ von der Steuereinheit 5 an den Operationsverstärker OP2 und somit an die spannungsgesteuerte Stromquellenschaltung 2 wird die Leistung des Halbleiterschalters 3 in allen Betriebszuständen von der Steuereinheit 5 kontrolliert. Dadurch kann der Halbleiterschalter 3 hinsichtlich der zu beherrschenden Verlustleistung entsprechend kleiner dimensioniert werden.

Bei der gemäß dem Ausführungsbeispiel unter Verwendung eines PMOS-Feldeffekttransistiors vorteilhafterweise mit dem Ist-Soll-Vergleich arbeitenden spannungsgesteuerten Stromquellenschaltung 2 erfolgt praktisch automatisch eine Strombegrenzung im Überlast- oder Kurzschlussfall, indem der Halbleiterschalter 3 aufgrund der Bildung des Differenzwertes S am Ausgang A_{S} des Operationsverstärkers OP2 automatisch zugesteuert wird, wenn ein Schwellwert erreicht oder überschritten wird. So ist im Normalbetrieb der Differenzwertes S, d .h. der den Halbleiterschalter 3 als Steuersignal steuernde Spannungsdifferenzwert kleiner als Null (< 0V). In diesem Zustand kann die Steuereinheit 5 ruhen und ist entsprechend leistungsarm. Erst wenn der Differenzwertes S den Schwellwert S₀, nämlich S₀ = 0V überschreitet, also größer als Null (> 0V) wird, reagiert die Steuereinheit 5 und senkt den Sollwert Iₛₑₜ ab, wobei zuvor oder zeitgleich der Halbleiterschalter mittels des Differenzwertes S ≥ S₀ in die Strombergrenzung mit I_{L} ≤ Iₘₐₓ steuert. Anstelle des PMOS kann auch ein anderer MOSFET- oder bipolarer Transisitor-Typ als Halbleiterschalter 3 eingesetzt sein. Auch kann der Verstärker 8 entfallen oder als Verstärkerschaltung aufgebaut sein.

### Bezugszeichenliste

- 1: elektronischer Schutzschalter
- 2: spannungsgesteuerte Stromquellenschaltung
- 3: Halbleiterschalter
- 4: Strom-/Pluspfad
- 5: Steuereinheit/-einrichtung
- 6: Spannungseingang
- 7: Lastanschluss/-ausgang
- 8: Verstärker

- Aₗₛₑₜ: Ausgang
- A_{S}: Ausgang
- C1,2: Kondensator
- E₍₊₎: (positiver) Eingang
- E₍₋₎: invertierender Eingang
- E_{Vout}: Eingang
- E_{ILim}: Eingang
- L: Last
- OP1,2: Operationsverstärker
- Q2,4: Transistor
- R1-R8: ohmscher Widerstand
- I_{L}: Ausgangs-/Laststrom
- Iₘₐₓ: Maximal-/Strombegrenzungswert
- I_{Min}: Minimalwert
- I_{Nom}: Nominalwert
- Iₛₑₜ: Sollwert
- Vᵢₙ: Betriebs-/Eingangsspannung
- Vₒᵤₜ: Ausgangsspannung
- Pₘₐₓ: maximaler Leistungswert
- S: Differenzwert/Steuersignal
- S₀: Schwellwert

## Patentansprüche

1. Elektronischer Schutzschalter (1) mit einer Steuereinheit (5) und mit einem steuerbaren Halbleiterschalter (6), der in einen Strompfad (4) zwischen einem Spannungseingang (6) und einem Lastausgang (7) geschaltet ist,
- wobei der Halbleiterschalter (3) in eine spannungsgesteuerte Stromquellenschaltung (2) integriert ist, deren Ausgangsstrom (I_{L}) bei angeschlosssener Last (L) mittels der Steuereinheit (5) derart eingestellt ist, dass die Leistung des Halbleiterschalters (2) kleiner oder gleich einem maximalen Leistungswert (Pₘₐₓ) ist,und
- wobei die Steuereinheit (5) einen Sollwert (Iₛₑₜ) an die spannungsgesteuerte Stromquellenschaltung (2) ausgibt und von dieser einen Differenzwert (S) erhält, der aus einer Abweichung eines den Ausgangsstrom (I_{L}) repräsentierenden Istwertes (Iᵢₛₜ) vom Sollwert (Iₛₑₜ) gebildet und dem Halbleiterschalter (3) als Steuersignal zu dessen Ansteuerung zugeführt ist,
**dadurch gekennzeichnet,**
**dass** die Steuereinheit (5) im Überlast- oder Kurzschlussfall den Sollwert (Iₛₑₜ) des Ausgangsstroms (I_{L}) auf einen vorgebbaren oder vorgegebenen Minimalwert (I_{Min}) einstellt und bei über die Zeit ansteigender Ausgangsspannung (Vₒᵤₜ) der Stromquellenschaltung (2) auf einen Nominalwert (I_{Nom}) erhöht.

2. Elektronischer Schutzschalter (1) nach Anspruch 1,
**dadurch gekennzeichnet,**
**dass** die Ausgangsspannung (Vₒᵤₜ) der spannungsgesteuerten Stromquellenschaltung (2) der Steuereinheit (5) zugeführt ist, welche die Leistung des Halbleiterschalters (3), vorzugsweise aus der Ausgangsspannung (Vₒᵤₜ) und dem Sollwert (Iₛₑₜ), ermittelt und den maximalen Leistungswert (Pₘₐₓ) in Abhängigkeit von der Ausgangsspannung (Vₒᵤₜ) einstellt.

3. Elektronischer Schutzschalter (1) nach Anspruch 1 oder 2,
**dadurch gekennzeichnet,**
**dass** der steuerbare Halbleiterschalter (3) innerhalb der spannungsgesteuerten Stromquellenschaltung (2) derart angesteuert ist, dass im Überlastoder Kurzschlussfall der Ausgangsstrom (I_{L}) unter Berücksichtigung des maximalen Leistungswert (Pₘₐₓ) begrenzt ist.

4. Elektronischer Schutzschalter (1) nach einem der Ansprüche 1 bis 3,
**dadurch gekennzeichnet,**
**dass** die Steuereinheit (5) den Sollwert (Iₛₑₜ) des Ausgangsstroms (I_{L}) in Abhängigkeit von der Ausgangsspannung (Vₒᵤₜ) stufenweise erhöht.

5. Elektronischer Schutzschalter (1) nach einem der Ansprüche 1 bis 4,
dadruch gekennzeichnet,
dass die spannungsgesteuerte Stromquellenschaltung (2) einen Operationsverstärker (OP2) aufweist, dem eingangsseitig der Istwert (Iᵢₛₜ) und der Sollwert (Iₛₑₜ) des Ausgangsstroms (I_{L}) zugeführt ist, und der ausgangsseitig mit einem Eingang (E_{ILim}) der Steuereinheit (5) sowie mit dem Halbleiterschalter (3) steuerseitig verbunden ist.

6. Verfahren zur Steuerung eines elektronischen Schutzschalters (1) mit einem in eine spannungsgesteuerte Stromquellenschaltung (2) integrierten steuerbaren Halbleiterschalter (3),
- bei dem der Ausgangsstrom (I_{L}) der Stromquellenschaltung (2) als Istwert (Iᵢₛₜ) erfasst und dieser mit einem Sollwert (Iₛₑₜ) unter Bildung eines Differenzwert (S) verglichen wird, der als Steuersignal zur Ansteuerung des Halbleiterschalters (3) dient,
- bei dem der Sollwert (Iₛₑₜ) des Ausgangsstroms (I_{L}) der Stromquellenschaltung (2) derart eingestellt wird, dass die Leistung des Halbleiterschalters (2) stets kleiner oder gleich einem maximalen Leistungswert (Pₘₐₓ) ist,
**dadurch gekennzeichnet,**
- **dass** im Überlast- oder Kurzschlussfall der Sollwert (Iₛₑₜ) des Ausgangsstroms (I_{L}) auf einen Minimalwert (I_{Min}) eingestellt und anschließend in Abhängigkeit von der Ausgangsspannung (Vₒᵤₜ) der Stromquellenschaltung (2) nur dann auf einen Nominalwert (I_{Nom}) erhöht wird, wenn im zeitlichen Verlauf die Ausgangsspannung (Vₒᵤₜ) ansteigt.

7. Verfahren nach Anspruch 6,
**dadurch gekennzeichnet,**
**dass** der Ausgangsstrom (I_{L}) auf einen Stromwert (Iₘₐₓ) begrenzt wird, wenn der aus dem Istwert (Iᵢₛₜ) und dem Sollwert (Iₛₑₜ) gebildete Differenzwert (S) des Ausgangsstroms (I_{L}) einen Schwellwert (S₀) erreicht oder überschreitet.

8. Verfahren nach Anspruch 6 oder 7,
**dadurch gekennzeichnet,**
**dass** die Ausgangsspannung (Vₒᵤₜ) der Stromquellenschaltung (2) erfasst und der Sollwert (Iₛₑₜ) des Ausgangsstroms (I_{L}) in Abhängigkeit von der Ausgangsspannung (Vₒᵤₜ) eingestellt wird.

## Claims

1. Electronic circuit breaker (1) with a control unit (5) and with a controllable semiconductor switch (6), which is connected in a current path (4) between a voltage input (6) and a load output (7),
- wherein the semiconductor switch (3) is integrated into a voltage-controlled current source circuit (2), whose output current (I_{L}), when a load (L) is connected, is set by means of the control unit (5) in such a way that the power of the semiconductor switch (2) is less than or equal to a maximum power value (Pmax), and
- wherein the control unit (5) outputs a setpoint value (Iₛₑₜ) to the voltage-controlled current source circuit (2) and receives from the latter a differential value (S), which is formed from a deviation of an actual value (list) - representing the output current (I_{L}) - from the setpoint value (Iₛₑₜ) and is fed to the semiconductor switch (3) as a control signal for driving said semiconductor switch,
**characterized in**
**that** in the event of an overload or short circuit the control unit (5) sets the setpoint value (Iₛₑₜ) of the output current (I_{L}) to a predeterminable or predetermined minimum value (I_{Min}) and increases it to a nominal value (I_{Nom}) when the output voltage (Vₒᵤₜ) of the current source circuit (2) increases over time.

2. Electronic circuit breaker (1) according to claim 1,
**characterized in**
**that** the output voltage (Vₒᵤₜ) is fed to the voltage-controlled current source circuit (2) of the control unit (5), which determines the power of the semiconductor switch (3), preferably from the output voltage (Vₒᵤₜ) and the setpoint value (Iₛₑₜ), and sets the maximum power value (Pₘₐₓ) depending on the output voltage (Vout).

3. Electronic circuit breaker (1) according to claim 1 or 2,
**characterized in**
**that** the controllable semiconductor switch (3) within the voltage-controlled current source circuit (2) is driven in such way that in the event of overload or short circuit the output current (I_{L}) is limited, taking into account the maximum power value (Pₘₐₓ).

4. Electronic circuit breaker (1) according to one of claims 1 to 3,
**characterized in**
**that** the control unit (5) gradually increases the setpoint value (Iₛₑₜ) of the output current (I_{L}) in steps depending on the output voltage (Vₒᵤₜ).

5. Electronic circuit breaker (1) according to one of claims 1 to 4,
**characterized in**
**that** the voltage-controlled current source circuit (2) comprises an operational amplifier (OP2), to which the actual value (Iᵢₛₜ) and the setpoint value (Iₛₑₜ) of the output current (I_{L}) is supplied on the input side, and which is connected to an input (E_{ILim}) of the control unit (5) on the output side and to the half-conductor switch (3) on the control side.

6. Method for controlling an electronic circuit breaker (1) with a controllable semiconductor switch (3) integrated in a voltage-controlled current source circuit (2),
- in which the output current (I_{L}) of the current source circuit (2) is detected as an actual value (Iᵢₛₜ) and the latter is compared with a setpoint value (Iₛₑₜ) so as to form a differential value (S), which serves as a control signal for driving the semiconductor switch (3),
- in which the setpoint value (Iₛₑₜ) of the output current (I_{L}) of the current source circuit (2) is set in such way that the power of the semiconductor switch (2) is always less than or equal to a maximum power value (Pₘₐₓ),
**characterized in**
**that**, in the event of an overload or short circuit, the setpoint (Iₛₑₜ) of the output current (I_{L}) is set to a minimum value (I_{Min}) and then, depending on the output voltage (Vₒᵤₜ) of the current source circuit (2), is only increased to a nominal value (I_{Nom}), if the output voltage (Vₒᵤₜ) increases over time.

7. Method according to claim 6,
**characterized in**
**that** the output current (I_{L}) is limited to a current value (Iₘₐₓ) if the differential value (S) of the output current (I_{L}) formed from the actual value (Iᵢₛₜ) and the setpoint value (Iₛₑₜ) reaches or exceeds a threshold value (S₀).

8. Method according to claim 6 or 7,
**characterized in**
**that** the output voltage (Vₒᵤₜ) of the current source circuit (2) is detected and the setpoint value (Iₛₑₜ) of the output current (I_{L}) is set depending on the output voltage (Vₒᵤₜ).

## Revendications

1. Disjoncteur électronique (1) avec une unité de commande (5) et avec un commutateur à semi-conducteur (6) commandable, qui est connecté dans un trajet de courant (4) entre une entrée de tension (6) et une sortie de charge (7),
- dans lequel le commutateur à semi-conducteur (3) est intégré dans un circuit de source de courant (2) commandé en tension, dont le courant de sortie (I_{L}), lorsqu'une charge (L) est connectée, est réglé au moyen de l'unité de commande (5) de telle sorte que la puissance du commutateur à semi-conducteur (2) soit inférieure ou égale à une valeur de puissance maximale (Pₘₐₓ), et
- dans lequel l'unité de commande (5) délivre une valeur de consigne (Iₛₑₜ) au circuit de source de courant (2) commandé en tension et reçoit de ce dernier une valeur différentielle (S) qui est formée à partir d'un écart d'une valeur réelle (I_{act}) - représentant le courant de sortie (I_{L}) - par rapport à la valeur de consigne (Iₛₑₜ) et est fournie au commutateur à semi-conducteur (3) en tant que signal de commande pour la commande de ce dernier,
**caractérisé en ce**
**qu'**en cas de surcharge ou de court-circuit, l'unité de commande (5) fixe la valeur de consigne (Iₛₑₜ) du courant de sortie (I_{L}) à une valeur minimale (I_{Min}) prédéterminable ou prédéterminée et l'augmente à une valeur nominale (I_{Nom}) lorsque la tension de sortie (Vₒᵤₜ) du circuit de source de courant (2) augmente dans le temps.

2. Disjoncteur électronique (1) selon la revendication 1,
caractérisé en ce
en ce que la tension de sortie (Vₒᵤₜ) est alimentée au circuit de source de courant (2) commandé en tension de l'unité de commande (5), qui détermine la puissance du commutateur à semi-conducteur (3), de préférence à partir de la tension de sortie (Vₒᵤₜ) et de la valeur de consigne (Iₛₑₜ), et fixe la valeur de puissance maximale (Pₘₐₓ) en fonction de la tension de sortie (Vₒᵤₜ).

3. Disjoncteur électronique (1) selon la revendication 1 ou 2,
**caractérisé en ce**
**que** commutateur à semi-conducteur (3) commandable à l'intérieur du circuit de source de courant (2) commandé en tension est commandé de telle manière que le courant de sortie (I_{L}) est limité en cas de surcharge ou de court-circuit, compte tenu de la valeur de puissance maximale (Pₘₐₓ).

4. Disjoncteur électronique (1) selon l'une des revendications 1 à 3,
**caractérisé en ce**
**que** l'unité de commande (5) augmente progressivement la valeur de consigne (Iₛₑₜ) du courant de sortie (I_{L}) en fonction de la tension de sortie (Vₒᵤₜ).

5. Disjoncteur électronique (1) selon l'une des revendications 1 à 4,
**caractérisé en ce**
**que** le circuit de source de courant (2) commandé en tension comporte un amplificateur opérationnel (OP2), auquel la valeur réelle (I_{act}) et la valeur de consigne (Iₛₑₜ) du courant de sortie (I_{L}) est fournie du côté de l'entrée, et qui est relié du côté de la sortie à une entrée (E_{ILim}) de l'unité de commande (5) et du côté de la commande au commutateur à semi-conducteur (3).

6. Procédé de commande d'un disjoncteur électronique (1) avec un commutateur à semi-conducteur (3) commandable intégré dans un circuit de source de courant (2) commandé en tension,
- dans lequel le courant de sortie (I_{L}) du circuit de source de courant (2) est détecté comme une valeur réelle (I_{act}) et cette dernière est comparée à une valeur de consigne (Iₛₑₜ), en formant une valeur différentielle (S), qui sert de signal de commande pour la commande du commutateur à semi-conducteur (3),
- dans lequel la valeur de consigne (Iₛₑₜ) du courant de sortie (I_{L}) du circuit de source de courant (2) est réglée de telle sorte que la puissance du commutateur à semi-conducteur (2) soit toujours inférieure ou égale à une valeur de puissance maximale (Pₘₐₓ),
**caractérisé en ce**
- **qu'**en cas de surcharge ou de court-circuit, la valeur de consigne (Iₛₑₜ) du courant de sortie (I_{L}) est fixée à une valeur minimale (I_{Min}) et ensuite, en fonction de la tension de sortie (Vₒᵤₜ), n'est augmentée à une valeur nominale (I_{Nom}) que si la tension de sortie (Vₒᵤₜ) augmente dans le temps.

7. Procédé selon la revendication 6,
**caractérisé en ce**
**que** le courant de sortie (I_{L}) est limité à une valeur de courant (Iₘₐₓ) si la valeur différentielle (S) du courant de sortie (I_{L}) formée à partir de la valeur réelle (I_{act}) et de la valeur de consigne (Iₛₑₜ) atteint ou dépasse une valeur seuil (S₀).

8. Procédé selon la revendication 6 ou 7,
**caractérisé en ce**
**que** la tension de sortie (Vₒᵤₜ) du circuit de source de courant (2) est détectée et la valeur de consigne (Iₛₑₜ) du courant de sortie (I_{L}) est réglée en fonction de la tension de sortie (Vₒᵤₜ).
